# EUROPEAN PATENT SPECIFICATION

(11) **EP 3 842 814 B1**
(45) Date of publication and mention of the grant of the patent: **01.05.2024**
(21) Application number: 19383193.0
(22) Date of filing: 24.12.2019
(51) Int. Cl.: G01R 31/327, G01R 31/00

(54) **SYSTEM FOR DIAGNOSING THE PRESENCE OF AN ELECTRIC CURRENT FLOWING THROUGH AT LEAST TWO SECTIONS OF TWO DIRECT CURRENT (DC) LINES**
SYSTEM ZUR DIAGNOSE DES VORHANDENSEINS EINES DURCH MINDESTENS ZWEI ABSCHNITTE ZWEIER GLEICHSTROMLEITUNGEN STRÖMENDEN ELEKTRISCHEN STROMS
SYSTÈME DE DIAGNOSTIC DE LA PRÉSENCE D'UN COURANT ÉLECTRIQUE S'ÉCOULANT À TRAVERS AU MOINS DEUX SECTIONS DE DEUX LIGNES DE COURANT CONTINU (CC)

(43) Date of publication of application: 30.06.2021
(73) Proprietor: Fico Triad, S.A., 08028 Barcelona (ES)
(72) Inventor: SALA MASIP, Enric, 08232 Viladecavalls (ES); BOIRA ORTEGA, Laura, 08232 Viladecavalls (ES); GAIG FONT, Miquel, 08232 Viladecavalls (ES)
(74) Representative: Elzaburu S.L.P.

(56) References cited:
- EP-A1- 2 857 851
- US-A1- 2017 205 455

## Description

### FIELD OF THE INVENTION

The present invention relates to a system for diagnosing the condition of at least two sections of two direct current lines. More specifically, the system is related to the diagnosing of the condition a switching device.

### BACKGROUND OF THE INVENTION

The sections of the direct current line to be diagnosed may be, for instance, a contact of a switching device, a fuse or a lamp.

A switching device is used for switching an electrical power circuit. Switching devices may be designed to be directly connected to high-current load devices, for instance, to control electric motors in an electric or hybrid vehicle.

Switching devices have several components being the contacts the current-carrying part. Switching devices may be single pole, two, three or even multiple poles, having each pole its related contact or current currying element.

In some applications, switching on and off a circuit acting on one of the poles may be enough. But for other applications, and due to safety reasons, more than one pole or even all the poles need to be switched off. This is the case in batteries of electric and hybrid vehicles.

In the state of the art, if the state of several contacts are to be diagnosed in switching devices, several devices for diagnosing the state of one single contact have to be included.

Devices for determining the condition of a section of a line are known in the art. Such devices may, for instance, include circuitry having divider resistors intended for potential measurement.

In the case of high-voltage circuits this must be carried through multiple resistors arranged in series to adjust the measurement range, an isolation circuit to separate the high voltage potential (contact measurement) of the control circuit through the use of DC/DC converters and isolated buffers, and disconnect switches of the measuring resistor chain to avoid current to be permanently drawn. These devices are, thus, based on measuring the electrical potential on both sides of the sections of the direct current line to be diagnosed.

It is also known to use a device for diagnosing the condition of contacts or fuses that comprises:
- a current generator adapted to deliver an alternating current through the contact or fuse to be diagnosed,
- a computing or electronic module for verifying if the delivered current flows through the contact or fuse.

More specifically, it is known to use a device comprising a transformer to inject a voltage or current in parallel to a contact to diagnose. The current to the secondary and the primary of the transformer is analysed, if the current can flow through the primary and secondary of the transformer, then, the contact diagnose is closed. If the current can't flow, then the contact is open. Such prior art is found in EP2857851 and US2017/205455.

For the above case, one complete system comprising a transformer, a driving and a detection is used for each one of the contacts to be diagnosed in a switching device.

### SUMMARY OF THE INVENTION

It is an object of the present invention to provide a system for diagnosing the condition of at least two sections of two direct current (DC) lines.

The sections of the direct current line to be diagnosed may be, for instance, a contact of a switching device, a fuse or a lamp.

Thus, more specifically, it is also an object of the invention to provide a system for diagnosing the condition of at least two contacts of two direct current (DC) lines in a switching device.

The switching device or switching devices to be diagnosed by the system of the invention are of the kind that comprise at least two sections of two direct current lines. For instance, a switching device may have a first pole and a second pole, and therefore two sections may be diagnosed. As previously stated, in an embodiment these two sections may be two contacts.

The invention provides a system according to claim 1.

The system of the invention is able to diagnose the presence of an electric current flowing through at least two sections of two direct current (DC) lines. The system comprises a device for diagnosing the presence of an electric current flowing through section, the device being of the kind that comprises:
- a current generator adapted to deliver an alternating current (AC) to said sections to be diagnosed, and
- a computing or electronic module for verifying if the delivered current flows through said section,

The system object of the invention further comprises:
- an electric circuit comprising at least a first sub-circuit and a second sub-circuit:
   - the first sub-circuit connected to the device for diagnosing the presence of an electric current, the first sub-circuit being adapted to connect in parallel a first section of the first direct current (DC) line to be diagnosed and the device for diagnosing the presence of an electric current, and
   - the second sub-circuit connected to the device for diagnosing the the presence of an electric current, the second sub-circuit being adapted to connect in parallel a second section of the second direct current (DC) line to be diagnosed and the device for diagnosing the presence of an electric current, and
   - both sub-circuits are electrically connected and the system further comprising:
      ∘ means for allowing the circulation of the delivered alternating current (AC) through each sub-circuit,
      ∘ means for preventing the circulation of direct current (DC) between both sub-circuits and towards the device for diagnosing the presence of an electric current,

Therefore, the device for diagnosing the presence of an electric current, the first sub-circuit and the second sub-circuit are configured to separate the potentials between the first section and the second section and for decoupling the delivered current and the potentials of the first section and of the section contact.
- the first sub-circuit and the second sub-circuit having an impedance. The impedance of each of the sub-circuits being of different value seen from the device for diagnosing the presence of an electric current and the computing or electronic module being adapted to assess the impedance of the alternating current (AC) delivered to the first and second sections.

The alternating delivered current can flow to the first section through the first sub-circuit and its related impedance and to the second section through the second sub-circuit and its related impedance. As the impedance of the first sub-circuit differs from the impedance of the second sub-circuit, thus, the impedance of the loop of the first sub-circuit is different from the impedance of the loop of the second sub-circuit.

Therefore, the computing or electronic module can identify the status of, at least, a first and a second section because the impedance of the delivered current is different depending on the state of the section. In the case of the sections being contacts, the impedance differs depending on which contact is open or closed.

As stated, the impedance of each of the sub-circuits is of different value seen from the device for diagnosing the presence of an electric current. It means that the value of the impedance of each sub-circuit is settled when no current flows towards the other sub-circuits. In case of contacts, when the impedance of a sub-circuit is being settled, the contacts of the other sub-circuits are in an open state.

The system object of the invention has the advantage that only one circuit detector is used to assess the state of more than one section.

It is also an object of the present invention a system for electric vehicle, the system characterized in that it comprises:
- a battery comprising a positive and a negative pole,
- a switch comprising two contacts in connection with the positive and the negative pole of the battery, and
- the system as described above for diagnosing the condition of said two contacts, the first sub-circuit being in connection with the first contact and the second sub-circuit being in connection with the second contact.

### DESCRIPTION OF THE FIGURES

To complete the description and in order to provide for a better understanding of the invention, drawings are provided. Said drawings form an integral part of the description and illustrate a preferred embodiment of the invention. The drawings comprise the following figures.
Figure 1 shows a circuit diagram of three single-poles switching devices and of an embodiment of the system for diagnosing the condition of a contact in a switching device.
Figure 2 shows a circuit diagram of three single-poles switching devices and of a second embodiment of the system for diagnosing the condition of a contact in a switching device.
Figure 3 shows a circuit diagram of three single-poles switching devices and of a third embodiment of the system for diagnosing the condition of a contact in a switching device.
Figure 4 shows a circuit diagram of three single-poles switching devices and of a fourth embodiment of the system for diagnosing the condition of a contact in a switching device.
Figure 5 shows a circuit diagram of an embodiment of a device for diagnosing the presence of an electric current flowing through a section.
Figure 6 shows a circuit diagram of a second embodiment of a device for diagnosing the presence of an electric current flowing through a section.
Figure 7 shows a circuit diagram of a third embodiment of a device for diagnosing the presence of an electric current flowing through a section.

### DETAILED DESCRIPTION OF THE INVENTION

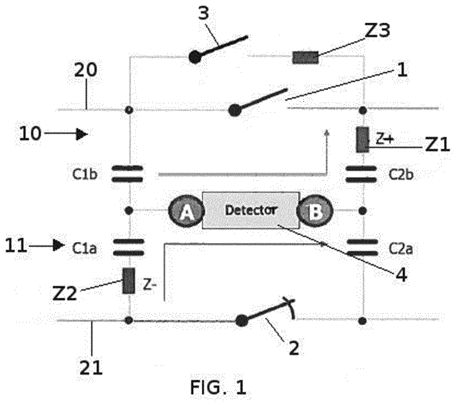

Figure 1 shows an embodiment of two single-pole switches, having two current lines (20, 21) and first and second contacts (1, 2), one located in each direct current line (20, 21).

Additionally, the shown embodiment comprises a further single-pole switch which its further contact (3) intended for precharging the electrical power system.

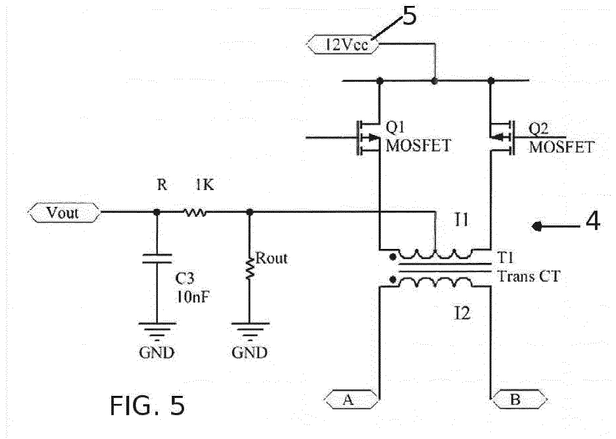

The shown embodiment of the system comprises:
- a device (4) or detector for diagnosing the condition of the first and second contacts (1, 2) and optionally for diagnosing the condition of the further contact (3). Instead of contacts (1, 2, 3) a fuse or a lamp or any other section of the direct current line (20, 21) may be diagnosed by the device (4) according to the invention.
The device (4) comprises:
- A current generator (5), as depicted in the embodiment shown in figures 5 to 7. The current generator (5) is adapted to deliver an alternating current (AC) through at least the first, second or third contact (1, 2, 3) to be diagnosed.
- A computing or electronic module for verifying if the delivered current flows through the first, second and/or third contact (1, 2).

The computing or electronic module serves the purpose of verifying if the generated current flows through the contacts (1, 2, 3) and, therefore, to determine which of the contacts (1, 2, 3) are either in an on condition or in an off condition.

The computing/electronic module may comprise one or more of an electronic module, a computing module and logic gate module.

The system shown in figure 1 comprises an electric circuit comprising a first sub-circuit (10) and a second sub-circuit (11). The second sub-circuit (11) and the first sub-circuit (10) are connected.

The first sub-circuit (10) is adapted to connect in parallel the first contact (1) and the device (4) for diagnosing the condition of the contact (1). The second sub-circuit (11) is adapted to connect in parallel the second contact (2) and the device (4) for diagnosing the condition of the contact (2).

Additionally, in the shown embodiment, the first sub-circuit (10) comprises a first impedance (Z₁) and the second sub-circuit (11) comprises a second impedance (Z₂). The value of Z₁ differs from Z₂, i.e., the absolute value of both impedances (Z₁, Z₂) differs.

The first impedance (Z₁) is adapted to be connected in series with the first contact (1), or section, and with the device (4) for diagnosing the condition of the first and further contacts (1, 3). Alternatively or additionally, the second impedance (Z₂) is adapted to be connected in series with the second contact (2), or section, and with the device (4) for diagnosing the condition of the contact (2). Both, first and second impedances (Z₁ ,Z₂) may be the intrinsic impedance of the circuit seen from the device (4).

According to the above, the current generator (5) is adapted to deliver an alternating current (AC) that flows through the first sub-circuit (10) and through the second sub-circuit (11). The delivered alternating current (AC) is adapted to flow through a first section, i.e., a first contact (1) in the shown embodiment, and to go back to the device (4). The delivered alternating current (AC) is also adapted to flow through the second section, i.e. the second contact (2), and to go back to the device (4).

Moreover, the device (4) for diagnosing the presence of an electric current flowing through a section comprises a first and a second electrical terminals (A, B). Additionally, both the first sub-circuit (10) and the second sub-circuit (11) are joined with each other (10, 11) and are jointly connected to said both terminals (A, B).

The claimed system further comprises:
- means for allowing the circulation of the delivered alternating current (AC) through each sub-circuit (10, 11), and
- means for preventing the circulation of direct current (DC) between both sub-circuits (10, 11) and towards the device (4) for diagnosing the presence of an electric current.

Specifically, the means for allowing the circulation of the delivered alternating current (AC) through each sub-circuit (10, 11) and for preventing the circulation of direct current (DC) between both sub-circuits (10, 11) and towards the device (4) for diagnosing the presence of an electric current may be a condenser (C1b, C1a, C2b, C2a).

In order to achieve the above effective isolation, at a minimum the system comprises at least a condenser (C1b, C1a, C2b, C2a) located in each one of the electrical connections between both sub-circuits (10, 11) and located in each one of the electrical connections between the device (4) for diagnosing the presence of an electric current flowing through a section and each section or contact (1, 2, 3).

In the embodiment shown in figure 1, each first and second sub-circuit (10, 11) comprises a condenser (C1b, C1a, C2b, C2a). Said condensers (C1b, C1a, C2b, C2a) separate the current lines (20, 21) through DC currents, but connect the current lines (20,21) through alternating currents provided by the current generator (5).

More specifically, the system disclosed in the embodiment of figure 1 comprises:
- a first condenser (C1b) connected in series with the first contact (1) and with the first terminal (A) of the device (4),
- a second condenser (C2b) connected in series with the first contact (1) and with the second terminal (B) of the device (4), and, thus, also connected in series with the first condenser (C1b) seen from the device (4),
- a third condenser (C1a) connected in series with the second contact (2) and with the first terminal (A) of the device (4), and, thus, also connected in parallel with the first condenser (C1b) seen from the device (4),
- a fourth condenser (C2a) connected in series with the second contact (1) and with the second terminal (B) of the device (4), also, thus, connected in series with the third condenser (C1a) seen from the device (4), and also connected in parallel with the second condenser (C2b) also seen from the device (4).

Therefore, the electric circuit of the embodiment of figure 1 has for the first sub-circuit (10) an equivalent impedance of the impedances of the first and second condensers (C1b, C2b) and of the impedance Z1 which are all located in series seen from the device (4). Equally, the electric circuit has for the second sub-circuit (11) an equivalent impedance of the impedances of the third and fourth condensers (C1a, C2a) and of the impedance Z2 which are all located in series seen from the device (4). And, thus, the device (4) will see a final equivalent impedance from the equivalent impedance of the first sub-circuit (10) and of the second sub-circuit (11) which are both located in parallel seen from the device (4) for diagnosing the presence of an electric current flowing through both contacts (1, 2).

Condensers (C1b, C1a, C2b, C2a), therefore, allow decoupling between both direct current lines (20, 21) and between the contact (1, 2) and the device (4) for diagnosing the condition of the contacts (1, 2). Condensers (C1b, C1a, C2b, C2a) are able to isolate the device (4) from the main current lines (20, 21) as it only allows to flow the alternate current from the device (4) to the contacts (1, 2).

Figures 5 to 7 show different embodiments of the device (4) for diagnosing the condition of the contacts (1, 2, 3). The shown devices (4) comprise:
- a current generator (5) adapted to deliver an alternating current through the sections or contacts (1, 2, 3) to be diagnosed,
- a first and a second electrical terminals (A, B), and
- a computing or electronic module for verifying if the delivered current flows through the contacts (1, 2, 3).

More specifically, it further comprises:
- a first sub-module comprising the primary side of a transformer (T1) and the current generator (5) both located in series,
- a second sub-module connected in parallel to the first sub-module and comprising the secondary side of the transformer (T1) and the first and the second electrical terminals (A, B) which are located in series with said secondary side of the transformer (T1), and
- a third sub-module comprising a microcontroller (not shown) adapted to receive an ouput signal (Vout) from the transformer (T1).
The transformer (T1) may be configured for:
∘ separating potentials between the contacts (1, 2) to be diagnosed, and
∘ separating potentials between the contacts (1, 2) to be diagnosed and the computing or electronic module.

In the shown embodiments, the alternating current generator (5) comprises a direct voltage source and two transitors (Q1, Q2) which transform said direct current into alternating current.

Therefore, a set of transistors (Q1, Q2) is provided in the first sub-module for transforming the direct current generated by the current generator (5) into alternating current.

According to an embodiment, the current generator (5) is arranged such that the supply of the current reflected at the primary side of the transformer (T1) is suitably isolated from the supply of current lines (20, 21).

Additionally, the second sub-module of the device (4) may further comprise means adapted for decoupling the electrical potentials associated with the first and the second contacts (1, 2) to be diagnosed with the device (4).

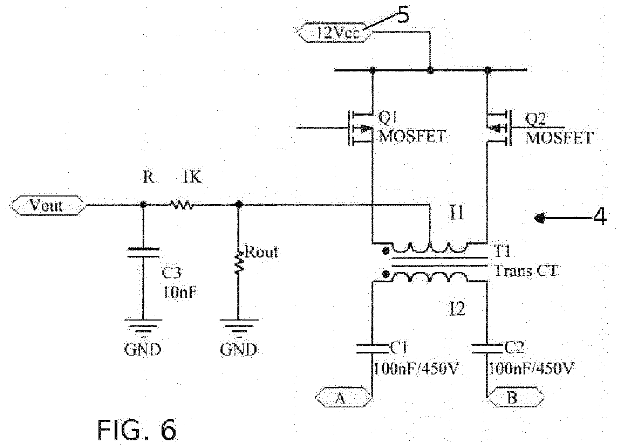

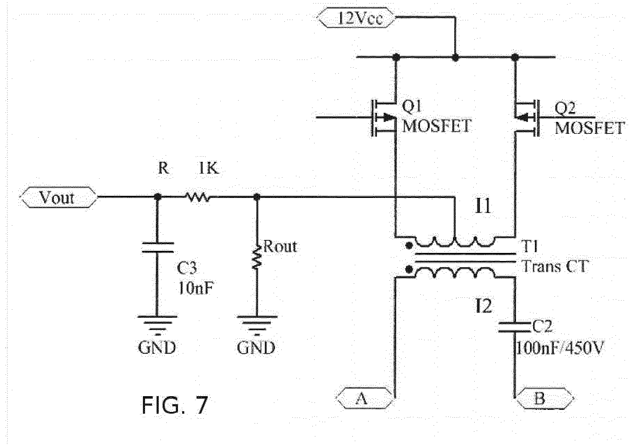

These means may further include a number of condensers (C1, C2). In figure 6, condensers (C1, C2) are provided in the secondary windings of transformer T1, specifically located between the transformer (T1) and the terminals (A, B). Condensers (C1, C2) allow decoupling between the generated current and possible potentials in the contacts (1, 2, 3) to be diagnosed. Figure 7 discloses only one condenser (C2).

As the system itself may comprise a set of condensers (C1b, C1a, C2b, C2a) in the first and the second sub-circuits (10, 11), the above condensers (C1, C2) from device (4) may be avoided, because its function is already performed by the condenser (C1b, C1a, C2b, C2a) from the system. Alternatively, some of the the condensers (C1b, C1a, C2b, C2a) located in the sub-circuits (10, 11) may be avoided.

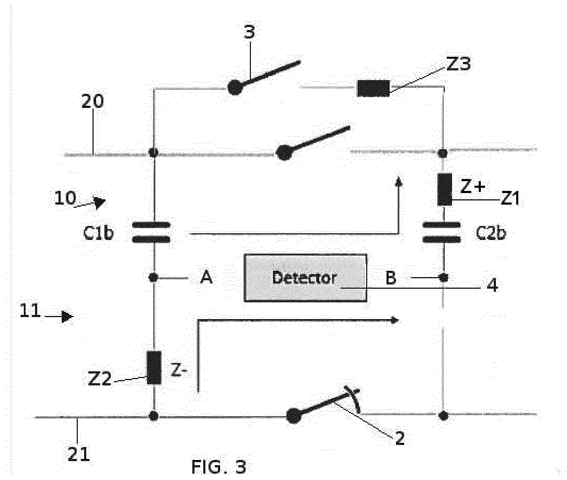

Figure 3 discloses an embodiment in which the first sub-circuit (10) comprises a first condenser (C1b) adapted to be connected in series with the first contact (1) and with the first terminal (A) of the device (4) and a second condenser (C2b) adapted to be connected in series with the first contact (1) and with the second terminal (B) of the device (4). In turn, the device (4) for diagnosing the presence of an electric current flowing through a section comprises the first condenser (C1) located between the transformer (T1) and the first terminal (A) and the second condenser (C2) located between the transformer (T1) and the second terminal (B).

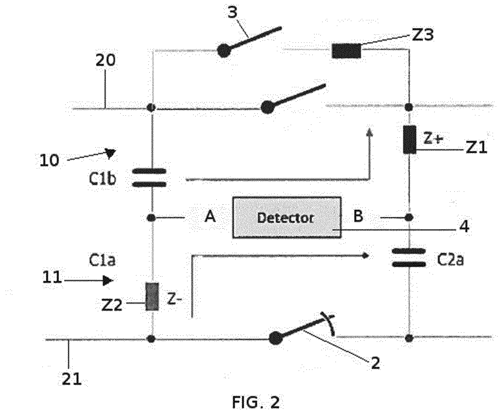

Figure 2 discloses another embodiment in which the first sub-circuit (10) comprises a first condenser (C1b) adapted to be connected in series with the first contact (1) and with the first terminal (A) of the device (4) and the second sub-circuit (11) comprises a second condenser (C2b) adapted to be connected in series with the second contact (2) and with the second terminal (B) of the device (4). In turn, the device (4) for diagnosing the presence of an electric current flowing through a section comprises the first condenser (C1) located between the transformer (T1) and the first terminal (A) and the second condenser (C2) located between the transformer (T1) and the second terminal (B).

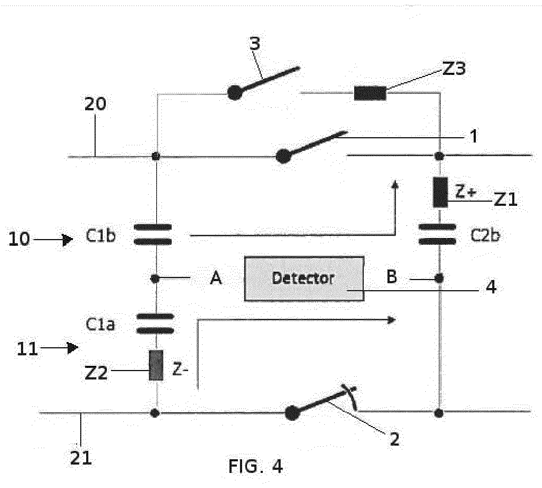

Figure 4 discloses a fourth embodiment or combination. The first sub-circuit (10) comprises a first condenser (C1b) adapted to be connected in series with the first contact (1) and with the first terminal (A) of the device (4), a second condenser (C2b) adapted to be connected in series with the first contact (1) and with the second terminal (B) of the device (4), the second sub-circuit (11) comprises a third condenser (C1a) adapted to be connected in series with a second contact (2) and with the first terminal (A) of the device (4). Additionally, the device (4) is configured as in the embodiment of figure 7. The device (4) comprises a fourth condenser (C2) located between the transformer (T1) and the second terminal (B).

In the embodiment shown in figures 3 and 4 the condensers (C1b, C2b) located in the first sub-circuit (10) are different from the condensers located in the second sub-circuit (11), none in the embodiment of figure 3 and a condenser (C1a) in the embodiment of figure 4. In these embodiments as both sub-circuits (10, 11), due to the different configuration of the condensers, they already have different impedances in the condensers themselves, an additional impedance may be not needed in the sub-circuits (10, 11) for being differenciates from the device (4).

Figures 5 to 7 discloses devices (4) for diagnosing the presence of an electric current that further may include filters, other resistances (Rout, R), condensers (C3) intended to adapt the output signal Vout that is being sent to the computing or electronic module for verifying if the delivered current flows through the contacts (1, 2, 3) (not shown).

The system disclosed in figures 1 to 4 comprise a further section, specifically a single-pole switch or contact (3) connected in parallel with the first contact (1) through an electric circuit (12). The electric circuit (12) comprises or consists in an impedance (Z₃) seen from the device (4) for diagnosing the presence of an electric current of different value of the impedances (Z₁, Z₂) of the first sub-circuit (10) and of the second sub-circuit (11). Specifically, the electric circuit (12) comprises an impedance (Z₃) connected in series with the further contact (3), that impedance (Z₃) could be the intrinsic impedance of that electric circuit (12).

The further contact (3) could be related to a precharging system. When initially, the further contact (3) is closed and the first (1) contact is open and precharging of the electrical power system is performed. Afterwards, the further contact (3) is open and the first contact (1) is closed.

Additionally, the impedance (Z₁) of the first sub-circuit (10) is connected in series with the impedance (Z₃) of the electrical circuit (12) comprising the further contact (3).

In an embodiment, the first impedance (Z₁) and the second impedance (Z₂) is between 10 kilo-ohms and 100 kilo-ohms and the impedance (Z₃) of the electric circuit (12) of the further contact (3) is between 25 ohms and 200 ohms.

In an embodiment, the device (4) for diagnosing the condition of the contacts (1, 2, 3) would asses the state of the contacts (1, 2, 3) as it is represented in the following table.

| **SECOND CONTACT (2)** | **FIRST CONTACT (1)** | **FURTHER CONTACT (3)** | **DEVICE (4)** |
|---|---|---|---|
| OPEN | OPEN | OPEN | Z --> INFINITE |
| OPEN | OPEN | CLOSE | Z₁ + Z₃ |
| OPEN | CLOSE | OPEN | Z1 |
| OPEN | CLOSE | CLOSE | (∼ Z1)* (due to Z3 is in parallel with a shortcircuit) |
| CLOSE | OPEN | OPEN | Z₂ |
| CLOSE | OPEN | CLOSE | (Z₂) in parallel with ((Z₁) + Z₃) |
| CLOSE | CLOSE | OPEN | (Z₂) in parallel with (Z₁) |
| CLOSE | CLOSE | CLOSE | (Z₂) in parallel with (∼Z₁)* (due to Z₃ is in parallel with a shortcircuit) |

The system is designed for primarily closing the precharging further contact (3) and when the precharging of the power system is performed, the first contact (1) is closed. In an application for an electric vehicle, not knowing if the further contact (3) relating to the precharging system is open would not impact the functioning of the switching device because most of the current would go through the first contact (1) and not through the further contact (3). Afterwards, when first and further (1, 3) contacts are closed, it could be known if the further contact (3) malfunctions or not.

The computing or electronic module for verifying if the delivered current flows through the sections or contacts (1, 2), specifically the microcontroller of the computing or electronic module, is adapted to store the value of at least the impedances or the related tensions of the first sub-circuit (10), of the second sub-circuit (11) and of the first and the second sub-circuits (10, 11) in parallel. The computing or electronic module, specifically the microcontroller as stated, is also adapted to receive the output tension (Vout) that is related with the equivalent impedance seen from the device (4) between the terminals (A, B) and is configured to compare the received tension (Vout) with the stored values, which may be a table of impedance values or a table of voltage values.

## Claims

1. System for diagnosing the condition of at least two sections of two direct current, DC, lines (20, 21), the system comprising a device (4) for diagnosing the presence of an electric current flowing through a section of a direct current, DC, line, the device (4) comprising:
- a current generator (5) adapted to deliver an alternating current , AC, to said section to be diagnosed,
- a first and a second electrical terminals (A, B), and
- a computing or electronic module for verifying if the delivered current flows through said section,
**characterized in that** the system further comprises an electric circuit comprising at least a first sub-circuit (10) and a second sub-circuit (11):
- the first sub-circuit (10) connected to the device (4) for diagnosing the presence of an electric current, the first sub-circuit (10) being adapted to connect in parallel a first section of the first direct current, DC, line (20) to be diagnosed and the terminals (A, B) of the device (4) for diagnosing the presence of an electric current, and
- the second sub-circuit (11) connected to the device (4) for diagnosing the presence of an electric current, the second sub-circuit (11) being adapted to connect in parallel a second section of the second direct current, DC, line (21) to be diagnosed and the and the terminals (A, B) of the device (4) for diagnosing the presence of an electric current,
- both sub-circuits (10, 11) being electrically connected and the system further comprising:
- means for allowing the circulation of the delivered alternating current, AC, through each sub-circuit (10, 11), and
- means for preventing the circulation of direct current, DC, between both sub-circuits (10, 11) and towards the device (4) for diagnosing the presence of an electric current,
- the first sub-circuit (10) and the second sub-circuit (11) having an impedance, the impedance of each of the sub-circuits (10, 11) being of different value seen from the device (4) for diagnosing the presence of an electric current, and the computing or electronic module being adapted to assess the impedance of the alternating current, AC, delivered to the first and second sections.

2. System for diagnosing the condition of at least two sections of two direct current, DC, lines (20, 21), according to claim 1, wherein the current generator (5) is adapted to deliver an alternating current , AC, that flows through the first sub-circuit (10) and through the second sub-circuit (11), the delivered alternating current, AC, being adapted to flow through a first section and to go back to the device (4) and through a second section and to go back to the device (4).

3. System for diagnosing the condition of at least two sections of two direct current, DC, lines (20, 21), according to claims 1 or 2, wherein both the first sub-circuit (10) and the second sub-circuit (11) being joined with each other (10, 11) and jointly connected to said both terminals (A, B).

4. System for diagnosing the condition of at least two sections of two direct current, DC, lines (20, 21), according to any preceding claim, wherein the first sub-circuit (10) comprises a first impedance (Z₁) adapted to be connected in series with a first section and with the device (4) for diagnosing the presence of an electric current flowing through a section and/or the second sub-circuit (11) comprises a second impedance (Z₂) of different value of the first impedance (Z₁) and adapted to be connected in series with a second section and with the device (4) for diagnosing the presence of an electric current flowing through a section.

5. System for diagnosing the condition of at least two sections of two direct current, DC, lines (20, 21), according to any preceding claim, wherein the means for allowing the circulation of the delivered alternating current , AC, through each sub-circuit (10, 11) and for preventing the circulation of direct current DC, between both sub-circuits (10, 11) and towards the device (4) for diagnosing the presence of an electric current is a condenser (C1b, C1a, C2b, C2a).

6. System for diagnosing the condition of at least two sections of two direct current DC, lines (20, 21), according to claim 5, wherein it comprises at least a condenser (C1b, C1a, C2b, C2a) located in each one of the electrical connections between both sub-circuits (10, 11) and located in each one of the electrical connections between the device (4) for diagnosing the presence of an electric current flowing through a section and each section.

7. System for diagnosing the condition of at least two sections of two direct current, DC, lines (20, 21), according to claim 6, wherein it comprises a first condenser (C1b) adapted to be connected in series with a first section and with the first terminal (A) of the device (4), a second condenser (C2b) adapted to be connected in series with the first section and with the second terminal (B) of the device (4), a third condenser (C1a) adapted to be connected in series with a second section and with the first terminal (A) of the device (4) and a fourth condenser (C2a) adapted to be connected in series with the second section and with the second terminal (B) of the device (4).

8. System for diagnosing the condition of at least two sections of two direct current, DC, lines (20, 21), according to any preceding claim, wherein the device (4) for diagnosing the presence of an electric current flowing through a section comprises:
- a first sub-module comprising the primary side of a transformer (T1) and the alternating current generator (5) located in series,
- a second sub-module connected in parallel with the first sub-module and comprising the secondary side of the transformer (T1) and the first and the second electrical terminals (A, B) which are located in series with said secondary side of the transformer (T1), and
- a third sub-module comprising a microcontroller adapted to receive an ouput signal (Vout) from the transistor (T1).

9. System for diagnosing the condition of at least two sections of two direct current, DC, lines (20, 21), according to claim 8, wherein the device (4) for diagnosing the presence of an electric current flowing through a section comprises a first condenser (C1) located between the transformer (T1) and the first terminal (A) and a second condenser (C2) located between the transformer (T1) and the second terminal (B).

10. System for diagnosing the condition of at least two sections of two direct current, DC, lines (20, 21), according to claim 9, wherein the first sub-circuit (10) comprises a first condenser (C1b) adapted to be connected in series with the first section and with the first terminal (A) of the device (4) and a second condenser (C2b) adapted to be connected in series with the first section and with the second terminal (B) of the device (4).

11. System for diagnosing the condition of at least two sections of two direct current, DC, lines (20, 21), according to claim 9, wherein the first sub-circuit (10) comprises a first condenser (C1b) adapted to be connected in series with the first section and with the first terminal (A) of the device (4) and the second sub-circuit (11) comprises a second condenser (C2b) adapted to be connected in series with the second section and with the second terminal (B) of the device (4), the device (4) for diagnosing the presence of an electric current flowing through a section comprises the first condenser (C1) located between the transformer (T1) and the first terminal (A) and the second condenser (C2) located between the transformer (T1) and the second terminal (B).

12. System for diagnosing the condition of at least two sections of two direct current, DC, lines (20, 21), according to any preceding claim, wherein the two direct current, DC, lines (20, 21) comprise a further section connected in parallel with the first sub-circuit (10) through an electric circuit (12) comprising an impedance (Z₃) seen from the device (4) for diagnosing the presence of an electric current, wherein the impedances of the first sub-circuit (10) and of the second sub-circuit (11) are of different value of the impedance (Z₃) of the electric circuit (12) of the further section.

13. System for diagnosing the condition of at least two sections of two direct current, DC, lines (20, 21), according to any preceding claim, wherein the computing or electronic module for verifying if the delivered current flows through the sections is adapted to:
- store the value of at least the impedances of the first sub-circuit (10), of the second sub-circuit (11) and of the first and the second sub-circuits (10, 11) in parallel or its related tensions,
- to receive an output tension (Vout) that is related with the equivalent impedance seen from the device (4) for diagnosing between the terminals (A, B), and
- to compare the received tension (Vout) with the stored values.

14. System for diagnosing the condition of at least two sections of two direct current, DC, lines (20, 21), according to any preceding claim, wherein the two sections of the two direct current, DC, lines (20, 21) respectively comprise first and a second contacts (1, 2).

15. System for electric vehicle, the system comprising:
- a battery comprising a positive and a negative pole,
- a switch comprising two contacts (1, 2) in connection with the positive and the negative pole of the battery, and
- the system for diagnosing the condition of said two contacts (1, 2) according to any preceding claim, the first sub-circuit (10) being in connection with the first contact (1) and the second sub-circuit (11) being in connection with the second contact (2).

## Patentansprüche

1. System zur Diagnose des Zustands von mindestens zwei Abschnitten zweier Gleichstromleitungen (20, 21), das System umfassend eine Vorrichtung (4) zur Diagnose des Vorhandenseins eines elektrischen Stroms, der durch einen Abschnitt einer Gleichstromleitung fließt, wobei die Vorrichtung (4) Folgendes umfasst:
- einen Stromgenerator (5), der geeignet ist, einen Wechselstrom an den zu diagnostizierenden Abschnitt zu liefern,
- einen ersten und einen zweiten elektrischen Anschluss (A, B), und
- ein Rechen- oder Elektronikmodul zur Überprüfung, ob der gelieferte Strom durch den genannten Abschnitt fließt,
**dadurch gekennzeichnet, dass** das System außerdem einen elektrischen Schaltkreis umfasst, der mindestens einen ersten Teilschaltkreis (10) und einen zweiten Teilschaltkreis (11) umfasst:
- der erste Teilschaltkreis (10) ist mit der Vorrichtung (4) zur Diagnose des Vorhandenseins eines elektrischen Stroms verbunden, wobei der erste Teilschaltkreis (10) so ausgelegt ist, dass er einen ersten Abschnitt der ersten Gleichstromleitung (20), die diagnostiziert werden soll, und die Anschlüsse (A, B) der Vorrichtung (4) zur Diagnose des Vorhandenseins eines elektrischen Stroms parallel schaltet, und
- der zweite Teilschaltkreis (11) ist mit der Vorrichtung (4) zur Diagnose des Vorhandenseins eines elektrischen Stroms verbunden, wobei der zweite Teilschaltkreis (11) so ausgelegt ist, dass er einen zweiten Abschnitt der zweiten Gleichstromleitung (21), die diagnostiziert werden soll, und die Anschlüsse (A, B) der Vorrichtung (4) zur Diagnose des Vorhandenseins eines elektrischen Stroms parallel schaltet,
- wobei beide Teilschaltkreise (10, 11) elektrisch verbunden sind und das System ferner Folgendes umfasst:
- Mittel, die die Zirkulation des gelieferten Wechselstroms (AC) durch jeden Teilschaltkreis (10, 11) ermöglichen, und
- Mittel zur Verhinderung der Zirkulation von Gleichstrom, DC, zwischen den beiden Teilschaltkreisen (10, 11) und zur Vorrichtung (4) für die Diagnose des Vorhandenseins eines elektrischen Stroms,
- der erste Teilschaltkreis (10) und der zweite Teilschaltkreis (11) weisen eine Impedanz auf, wobei die Impedanz jedes der Teilschaltkreise (10, 11) von der Vorrichtung (4) zur Diagnose des Vorhandenseins eines elektrischen Stroms aus gesehen einen unterschiedlichen Wert hat, und das Rechen- oder Elektronikmodul so ausgelegt ist, dass es die Impedanz des Wechselstroms, AC, der an den ersten und zweiten Abschnitt geliefert wird, bewerten kann.

2. System zur Zustandsdiagnose von mindestens zwei Abschnitten zweier Gleichstromleitungen (20, 21) nach Anspruch 1, wobei der Stromgenerator (5) geeignet ist, einen Wechselstrom (AC) zu liefern, der durch den ersten Teilschaltkreis (10) und durch den zweiten Teilschaltkreis (11) fließt, wobei der gelieferte Wechselstrom (AC) geeignet ist, durch einen ersten Abschnitt zu fließen und zu der Vorrichtung (4) zurückzukehren und durch einen zweiten Abschnitt zu fließen und zu der Vorrichtung (4) zurückzukehren.

3. System zur Zustandsdiagnose von mindestens zwei Abschnitten zweier Gleichstromleitungen (20, 21) nach Anspruch 1 oder 2, wobei sowohl der erste Teilschaltkreis (10) als auch der zweite Teilschaltkreis (11) miteinander verbunden sind (10, 11) und gemeinsam mit den beiden Anschlüssen (A, B) verbunden sind.

4. System zur Zustandsdiagnose von mindestens zwei Abschnitten zweier Gleichstromleitungen (20, 21) nach einem der vorhergehenden Ansprüche,
wobei der erste Teilschaltkreis (10) eine erste Impedanz (Z₁) aufweist, die geeignet ist, mit einem ersten Abschnitt und mit der Vorrichtung (4) in Reihe geschaltet zu werden, um das Vorhandensein eines durch einen Abschnitt fließenden elektrischen Stroms zu diagnostizieren, und/oder der zweite Teilschaltkreis (11) eine zweite Impedanz (Z₂) mit einem von der ersten Impedanz (Z₁) verschiedenen Wert aufweist und ausgelegt ist, mit einem zweiten Abschnitt und mit der Vorrichtung (4) in Reihe geschaltet zu werden, um das Vorhandensein eines durch einen Abschnitt fließenden elektrischen Stroms zu diagnostizieren.

5. System zur Zustandsdiagnose von mindestens zwei Abschnitten zweier Gleichstromleitungen (20, 21) nach einem der vorhergehenden Ansprüche, wobei das Mittel, um die Zirkulation des gelieferten Wechselstroms (AC) durch jeden Teilschaltkreis (10, 11) zu ermöglichen und die Zirkulation von Gleichstrom (DC) zwischen den beiden Teilschaltkreisen (10, 11) und zur Vorrichtung (4) zur Diagnose des Vorhandenseins eines elektrischen Stroms zu verhindern, ein Kondensator (C1 b, C1 a, C2b, C2a) ist.

6. System zur Zustandsdiagnose von mindestens zwei Abschnitten zweier Gleichstromleitungen (20, 21) nach Anspruch 5, wobei es mindestens einen Kondensator (C1b, C1a, C2b, C2a) umfasst, der in jeder der elektrischen Verbindungen zwischen den beiden Teilschaltkreisen (10, 11) und in jeder der elektrischen Verbindungen zwischen der Vorrichtung (4) zur Diagnose des Vorhandenseins eines durch einen Abschnitt fließenden elektrischen Stroms und jedem Abschnitt angeordnet ist.

7. System zur Zustandsdiagnose von mindestens zwei Abschnitten zweier Gleichstromleitungen (20, 21) nach Anspruch 6, wobei es einen ersten Kondensator (C1b) umfasst, der mit einem ersten Abschnitt und mit dem ersten Anschluss (A) der Vorrichtung (4) in Reihe geschaltet werden kann, einen zweiten Kondensator (C2b), der mit dem ersten Abschnitt und mit dem zweiten Anschluss (B) der Vorrichtung (4) in Reihe geschaltet werden kann, einen dritten Kondensator (C1a), der mit einem zweiten Abschnitt und mit dem ersten Anschluss (A) der Vorrichtung (4) in Reihe geschaltet werden kann, und einen vierten Kondensator (C2a), der mit dem zweiten Abschnitt und mit dem zweiten Anschluss (B) der Vorrichtung (4) in Reihe geschaltet werden kann.

8. System zur Zustandsdiagnose von mindestens zwei Abschnitten zweier Gleichstromleitungen (20, 21) nach einem der vorhergehenden Ansprüche, wobei die Vorrichtung (4) zur Diagnose des Vorhandenseins eines durch einen Abschnitt fließenden elektrischen Stroms Folgendes umfasst:
- ein erstes Untermodul, das die Primärseite eines Transformators (T1) und den in Reihe geschalteten Wechselstromgenerator (5) umfasst,
- ein zweites Untermodul, das parallel zum ersten Untermodul geschaltet ist und die Sekundärseite des Transformators (T1) sowie den ersten und den zweiten elektrischen Anschluss (A, B) umfasst, die in Reihe an der Sekundärseite des Transformators (T1) angeordnet sind, und
- ein drittes Untermodul mit einem Mikrocontroller, der ein Ausgangssignal (Vout) von dem Transistor (T1) empfangen kann.

9. System zur Zustandsdiagnose von mindestens zwei Abschnitten zweier Gleichstromleitungen (20, 21) nach Anspruch 8, wobei die Vorrichtung (4) zur Diagnose des Vorhandenseins eines durch einen Abschnitt fließenden elektrischen Stroms einen ersten Kondensator (C1), der zwischen dem Transformator (T1) und dem ersten Anschluss (A) angeordnet ist, und einen zweiten Kondensator (C2), der zwischen dem Transformator (T1) und dem zweiten Anschluss (B) angeordnet ist, umfasst.

10. System zur Zustandsdiagnose von mindestens zwei Abschnitten zweier Gleichstromleitungen (20, 21) nach Anspruch 9, wobei der erste Teilschaltkreis (10) einen ersten Kondensator (C1b), der mit dem ersten Abschnitt und mit dem ersten Anschluss (A) der Vorrichtung (4) in Reihe geschaltet werden kann, und einen zweiten Kondensator (C2b) umfasst, der mit dem ersten Abschnitt und dem zweiten Anschluss (B) der Vorrichtung (4) in Reihe geschaltet werden kann.

11. System zur Zustandsdiagnose von mindestens zwei Abschnitten zweier Gleichstromleitungen (20, 21) nach Anspruch 9, wobei der erste Teilschaltkreis (10) einen ersten Kondensator (C1b) umfasst, der mit dem ersten Abschnitt und mit dem ersten Anschluss (A) der Vorrichtung (4) in Reihe geschaltet werden kann, und der zweite Teilschaltkreis (11) einen zweiten Kondensator (C2b) umfasst, der mit dem zweiten Abschnitt und mit dem zweiten Anschluss (B) der Vorrichtung (4) in Reihe geschaltet werden kann, die Vorrichtung (4) zur Diagnose des Vorhandenseins eines elektrischen Stroms, der durch einen Abschnitt fließt, umfasst den ersten Kondensator (C1), der zwischen dem Transformator (T1) und dem ersten Anschluss (A) angeordnet ist, und den zweiten Kondensator (C2), der zwischen dem Transformator (T1) und dem zweiten Anschluss (B) angeordnet ist.

12. System zur Zustandsdiagnose von mindestens zwei Abschnitten zweier Gleichstromleitungen (20,21) nach einem der vorhergehenden Ansprüche, wobei die beiden Gleichstromleitungen (20, 21) einen weiteren Abschnitt umfassen, der mit dem ersten Teilschaltkreis (10) über einen Schaltkreis (12) parallel geschaltet ist, der eine Impedanz (Z₃) aufweist, die von der Vorrichtung (4) zur Diagnose des Vorhandenseins eines elektrischen Stroms aus gesehen wird, wobei die Impedanzen des ersten Teilschaltkreises (10) und des zweiten Teilschaltkreises (11) einen unterschiedlichen Wert der Impedanz (Z₃) des Schaltkreises (12) des weiteren Abschnitts aufweisen.

13. System zur Zustandsdiagnose von mindestens zwei Abschnitten zweier Gleichstromleitungen (20,21) nach einem der vorhergehenden Ansprüche, wobei das Rechen- oder Elektronikmodul zur Überprüfung, ob der gelieferte Strom durch die Abschnitte fließt, für Folgendes geeignet ist:
- Den Wert mindestens der Impedanzen des ersten Teilschaltkreises (10), des zweiten Teilschaltkreises (11) und des ersten und des zweiten Teilschaltkreises (10, 11) parallel oder die zugehörigen Spannungen zu speichern,
- eine Ausgangsspannung (Vout) zu empfangen, die mit der äquivalenten Impedanz in Beziehung steht, die von der Vorrichtung (4) zur Diagnose zwischen den Anschlüssen (A, B) gesehen wird, und
- um die empfangene Spannung (Vout) mit den gespeicherten Werten zu vergleichen.

14. System zur Zustandsdiagnose von mindestens zwei Abschnitten zweier Gleichstromleitungen (20,21) nach einem der vorhergehenden Ansprüche, wobei die beiden Abschnitte der beiden Gleichstromleitungen (20, 21) jeweils einen ersten und einen zweiten Kontakt (1, 2) aufweisen.

15. System für ein elektrisches Fahrzeug, das System umfassend:
- eine Batterie mit einem positiven und einem negativen Pol,
- einen Schalter mit zwei Kontakten (1, 2), die mit dem positiven und dem negativen Pol der Batterie verbunden sind, und
- System zur Zustandsdiagnose der beiden Kontakte (1, 2) nach einem der vorhergehenden Ansprüche, wobei der erste Teilschaltkreis (10) mit dem ersten Kontakt (1) und der zweite Teilschaltkreis (11) mit dem zweiten Kontakt (2) in Verbindung steht.

## Revendications

1. Système de diagnostic de l'état d'au moins deux sections de deux lignes à courant continu (20, 21), le système comprenant un dispositif (4) pour diagnostiquer la présence d'un courant électrique circulant dans une section d'une ligne à courant continu, le dispositif (4) comprenant :
- un générateur de courant (5) adapté pour délivrer un courant alternatif (CA) à ladite section à diagnostiquer,
- une première et une deuxième bornes électriques (A, B), et
- un module informatique ou électronique permettant de vérifier si le courant délivré traverse ladite section,
**caractérisé par le fait que** le système comprend en outre un circuit électrique comprenant au moins un premier sous-circuit (10) et un second sous-circuit (11) :
- le premier sous-circuit (10) connecté au dispositif (4) pour diagnostiquer la présence d'un courant électrique, le premier sous-circuit (10) étant adapté pour connecter en parallèle une première section de la première ligne de courant continu (20) à diagnostiquer et les bornes (A, B) du dispositif (4) pour diagnostiquer la présence d'un courant électrique, et
- le deuxième sous-circuit (11) connecté au dispositif (4) de diagnostic de la présence d'un courant électrique, le deuxième sous-circuit (11) étant adapté pour connecter en parallèle une deuxième section de la deuxième ligne de courant continu (21) à diagnostiquer et les bornes (A, B) du dispositif (4) de diagnostic de la présence d'un courant électrique,
- les deux sous-circuits (10, 11) étant connectés électriquement et le système comprenant en outre :
- des moyens pour permettre la circulation du courant alternatif fourni, CA, à travers chaque sous-circuit (10, 11), et
- des moyens pour empêcher la circulation du courant continu, CC, entre les deux sous-circuits (10, 11) et vers le dispositif (4) pour diagnostiquer la présence d'un courant électrique,
- le premier sous-circuit (10) et le deuxième sous-circuit (11) ayant une impédance, l'impédance de chacun des sous-circuits(10, 11) étant de valeur différente vue du dispositif (4) de diagnostic de la présence d'un courant électrique, et le module informatique ou électronique étant adapté pour évaluer l'impédance du courant alternatif (CA) délivré aux première et deuxième sections.

2. Système de diagnostic de l'état d'au moins deux sections de deux lignes de courant continu (20, 21), selon la revendication 1, dans lequel le générateur de courant (5) est adapté pour délivrer un courant alternatif (CA) qui circule dans le premier sous-circuit (10) et dans le second sous-circuit (11), le courant alternatif (CA) délivré étant adapté pour circuler dans une première section et retourner au dispositif (4) et dans une seconde section et retourner au dispositif (4).

3. Système de diagnostic de l'état d'au moins deux sections de deux lignes de courant continu (20, 21), selon les revendications 1 ou 2, dans lequel le premier sous-circuit (10) et le second sous-circuit (11) sont reliés entre eux (10, 11) et connectés conjointement aux deux bornes (A, B).

4. Système de diagnostic de l'état d'au moins deux sections de deux lignes à courant continu (20, 21), selon l'une des revendications précédentes,
dans lequel le premier sous-circuit (10) comprend une première impédance (_{Z1}) adaptée pour être connectée en série avec une première section et avec le dispositif (4) pour diagnostiquer la présence d'un courant électrique traversant une section et/ou le deuxième sous-circuit (11) comprend une deuxième impédance (_{Z2}) d'une valeur différente de la première impédance (zi), et adaptée pour être connectée en série avec une deuxième section et avec le dispositif (4) pour diagnostiquer la présence d'un courant électrique traversant une section.

5. Système de diagnostic de l'état d'au moins deux sections de deux lignes de courant continu (20, 21), selon l'une quelconque des revendications précédentes, dans lequel le moyen pour permettre la circulation du courant alternatif (CA) délivré à travers chaque sous-circuit (10, 11) et pour empêcher la circulation du courant continu (CC) entre les deux sous-circuits (10, 11) et vers le dispositif (4) de diagnostic de la présence d'un courant électrique est un condensateur (C1 b, C1 a, C2b, C2a).

6. Système de diagnostic de l'état d'au moins deux tronçons de deux lignes à courant continu (20, 21), selon la revendication 5, dans lequel il comprend au moins un condenseur (C1b, C1a, C2b, C2a) situé dans chacune des connexions électriques entre les deux sous-circuits (10, 11) et situé dans chacune des connexions électriques entre le dispositif (4) de diagnostic de la présence d'un courant électrique circulant dans un tronçon et chaque tronçon.

7. Système de diagnostic de l'état d'au moins deux tronçons de deux lignes à courant continu (20, 21), selon la revendication 6, qui comprend un premier condenseur (C1b) adapté pour être connecté en série avec un premier tronçon et avec la première borne (A) du dispositif (4), un deuxième condenseur (C2b) adapté pour être connecté en série avec le premier tronçon et avec la deuxième borne (B) du dispositif (4), un troisième condenseur (C1a) adapté pour être connecté en série avec un deuxième tronçon et avec la première borne (A) du dispositif (4) et un quatrième condenseur (C2a) adapté pour être connecté en série avec le deuxième tronçon et avec la deuxième borne (B) du dispositif (4).

8. Système de diagnostic de l'état d'au moins deux tronçons de deux lignes à courant continu (20, 21), selon l'une quelconque des revendications précédentes, dans lequel le dispositif (4) de diagnostic de la présence d'un courant électrique circulant dans un tronçon comprend :
- un premier sous-module comprenant le côté primaire d'un transformateur (T1) et le générateur de courant alternatif (5) situés en série,
- un deuxième sous-module connecté en parallèle avec le premier sous-module et comprenant le côté secondaire du transformateur (T1) et les premières et deuxièmes bornes électriques (A, B) qui sont situées en série avec ledit côté secondaire du transformateur (T1), et
- un troisième sous-module comprenant un microcontrôleur adapté pour recevoir un signal de sortie (Vout) du transistor (T1).

9. Système de diagnostic de l'état d'au moins deux tronçons de deux lignes à courant continu (20, 21), selon la revendication 8, dans lequel le dispositif (4) de diagnostic de la présence d'un courant électrique circulant dans un tronçon comprend un premier condenseur (C1) situé entre le transformateur (T1) et la première borne (A) et un second condenseur (C2) situé entre le transformateur (T1) et la seconde borne (B).

10. Système de diagnostic de l'état d'au moins deux tronçons de deux lignes à courant continu (20, 21), selon la revendication 9, dans lequel le premier sous-circuit (10) comprend un premier condenseur (C1 b) destiné à être connecté en série avec le premier tronçon et avec la première borne (A) du dispositif (4) et un second condenseur (C2b) destiné à être connecté en série avec le premier tronçon et avec la seconde borne (B) du dispositif (4).

11. Système de diagnostic de l'état d'au moins deux tronçons de deux lignes à courant continu (20, 21), selon la revendication 9, dans lequel le premier sous-circuit (10) comprend un premier condenseur (C1 b) destiné à être connecté en série avec le premier tronçon et avec la première borne (A) du dispositif (4) et dans lequel le deuxième sous-circuit (11) comprend un deuxième condenseur (C2b) destiné à être connecté en série avec le deuxième tronçon et avec la deuxième borne (B) du dispositif (4), le dispositif (4) de diagnostic de la présence d'un courant électrique circulant dans un tronçon comprend le premier condensateur (C1) situé entre le transformateur (T1) et la première borne (A) et le second condensateur (C2) situé entre le transformateur (T1) et la seconde borne (B).

12. Système de diagnostic de l'état d'au moins deux sections de deux lignes de courant continu (20, 21), selon l'une quelconque des revendications précédentes, dans lequel les deux lignes de courant continu (20, 21) comprennent un autre tronçon connecté en parallèle au premier sous-circuit (10) par un circuit électrique (12) comprenant une impédance (Z₃) vue du dispositif (4) de diagnostic de la présence d'un courant électrique, dans lequel les impédances du premier sous-circuit (10) et du deuxième sous-circuit (11) sont de valeur différente de l'impédance (Z₃) du circuit électrique (12) de l'autre tronçon.

13. Système de diagnostic de l'état d'au moins deux sections de deux lignes à courant continu (20, 21), selon l'une quelconque des revendications précédentes, dans lequel le module informatique ou électronique permettant de vérifier si le courant délivré circule dans les sections est adapté pour:
- mémoriser la valeur d'au moins les impédances du premier sous-circuit (10), du deuxième sous-circuit (11) et du premier et du deuxième sous-circuits (10, 11) en parallèle ou les tensions correspondantes,
- recevoir une tension de sortie (Vout) qui est liée à l'impédance équivalente vue du dispositif (4) de diagnostic entre les bornes (A, B), et
- pour comparer la tension reçue (Vout) avec les valeurs enregistrées.

14. Système de diagnostic de l'état d'au moins deux sections de deux lignes à courant continu (20, 21), selon l'une quelconque des revendications précédentes, dans lequel les deux sections des deux lignes à courant continu (20, 21) comprennent respectivement un premier et un second contact (1, 2).

15. Système pour véhicule électrique, le système comprenant :
- une batterie comprenant un pôle positif et un pôle négatif,
- un interrupteur comportant deux contacts (1, 2) en liaison avec le pôle positif et le pôle négatif de la batterie, et
- le système de diagnostic de l'état desdits deux contacts (1, 2) selon l'une quelconque des revendications précédentes, le premier sous-circuit-(10) étant en relation avec le premier contact (1) et le second sous-circuit (11) étant en relation avec le second contact (2).
